(19) Europäisches Patentamt
European Patent Office
Office européen des brevets

(11) **EP 4 715 402 A1**

(12) **EUROPÄISCHE PATENTANMELDUNG**

(43) Veröffentlichungstag:
**25.03.2026 Patentblatt 2026/13**

(21) Anmeldenummer: **24201061.9**

(22) Anmeldetag: **18.09.2024**

(51) Internationale Patentklassifikation (IPC):
**G01R 31/08** (2020.01)        **G01R 31/11** (2006.01)
**H02H 7/26** (2006.01)

(52) Gemeinsame Patentklassifikation (CPC):
**G01R 31/085; G01R 31/088; G01R 31/11;
H02H 7/265**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft
80333 München (DE)**

(72) Erfinder: **Blumschein, Jörg
14165 Berlin (DE)**

(74) Vertreter: **Siemens Patent Attorneys
Postfach 22 16 34
80506 München (DE)**

(54) **VERFAHREN ZUM ERMITTELN EINES FEHLERORTES IN EINEM ELEKTRISCHEN VERSORGUNGSNETZ**

(57) Die Erfindung betrifft ein Verfahren zum Ermitteln eines Fehlerortes (7) in einem elektrischen Energieversorgungsnetz (1), bei dem an einer ersten (a) und einer zweiten (b) Messstelle in dem Energieversorgungsnetz (1) mittels jeweils eines Messsensors (4a, 4b) jeweils eine elektrische Messgröße unter Gewinnung von einem ersten beziehungsweise einem zweiten Messsignal erfasst werden, wobei jeder Messensor (4a, 4b) mit jeweils einem intelligenten elektronischen Gerät IED (5a, 5b) verbunden ist und $L_{ab}$ die Gesamtlänge des Leiterabschnitts des Energieversorgungsnetzes zwischen der ersten (a) und der zweiten Messstelle (b) angibt, die Messsignale der ersten Messstelle (a) und der zweiten Messstelle (b) jeweils auf das Vorhandensein einer Wanderwelle (8a, 8b) untersucht werden. Aufgabe der Erfindung ist es, ein solches Verfahren, also eine Fehlerortung nach dem Wanderwellenprinzip, dahin weiterzuentwickeln, dass es genauer und gleichzeitig kostengünstiger wird. Dies wird im Rahmen der Erfindung dadurch geschafft, dass nach dem Feststellen des Vorliegens einer Wanderwelle (8a, 8b) an beiden Messstellen mit Hilfe der zeitlich ersten Reflexion der besagten Wanderwelle an der jeweiligen Sammelschiene und daran anschließend an dem Fehlerort (7) ein Laufzeitverhältnisfaktor F berechnet wird, der die Laufzeit der Wanderwelle (8a) vom Fehlerort (7) zur ersten Messstelle (a) im Verhältnis zur Laufzeit der besagten Wanderwelle (8a, 8b) von der ersten (a) zur zweiten Messstelle (b) angibt, und die Entfernung X des Fehlerortes (7) von der ersten Messstelle (a) aus dem Produkt aus dem Laufzeitverhältnisfaktor F und der Gesamtlänge $L_{ab}$, gemäß

$$X = F \cdot L_{ab},$$

berechnet wird.

FIG 1

Processed by Luminess, 75001 PARIS (FR)

**Beschreibung**

Die Erfindung betrifft ein Verfahren zum Ermitteln eines Fehlerortes in einem elektrischen Energieversorgungsnetz, bei dem an einer ersten und einer zweiten Messstelle in dem Energieversorgungsnetz mittels jeweils eines Messsensors jeweils eine elektrische Messgröße unter Gewinnung von einem ersten beziehungsweise einem zweiten Messsignal erfasst werden, wobei jede Messstelle in unmittelbarer Nähe oder an einer Sammelschiene angeordnet ist und jeder Messensor mit jeweils einem intelligenten elektronischen Gerät IED verbunden ist und $L_{ab}$, die Gesamtlänge des Leiterabschnitts des Energieversorgungsnetzes zwischen der ersten und der zweiten Messstelle oder den Sammelschienen angibt, die Messsignale der ersten Messstelle und der zweiten Messstelle jeweils auf das Vorhandensein einer Wanderwelle untersucht werden.

Der sichere Betrieb elektrischer Energieversorgungsnetze erfordert die schnelle und zuverlässige Erkennung und Abschaltung etwaiger Fehler, wie z.B. Kurzschlüsse oder Erdschlüsse. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten Fall findet eine Fehlerortung durch manuelle Inaugenscheinnahme statt. Dabei fährt ein Wartungsteam die fehlerhafte Leitung ab und untersucht sie auf sichtbare Fehlerstellen. Auch ist der Einsatz von Drohnen bekannt, die mit Kamaras ausgerüstet sind und die fehlerhafte Leitung überfliegen. Dabei werden ihre Bilddaten an eine Zentralstelle übertragen. Diese Vorgehensweisen sind jedoch zeitintensiv und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Aus der EP 2476002 B1 ist bekannt, die Eingrenzung des Fehlerortes durch die Feststellung der Fehlerrichtung zu erreichen. Diese Methode wird überwiegend in gelöschten, isolierten sowie hochohmig geerdeten Energieversorgungsnetzen mit einer radialen Struktur und einem geringen Vermaschungsgrad eingesetzt. Dabei kann beispielsweise eine wattmetrische Methode verwendet werden.

Verfahren zur genaueren Fehlerortung verwenden die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Die US 4,996,624 A beschreibt ein Fehlerortungsverfahren, bei dem Messwerte von nur einem Leitungsende verwendet werden. Der hierbei notwendige Aufwand zur Durchführung der Fehlerortung ist daher gering. Bei der besagten Fehlerortungsmethode handelt es sich überwiegend um ein impedanzbasiertes Verfahren, bei dem aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen.

Die US 5,929,642 A stellt ein Verfahren zur Fehlerortung bereit, das eine hörere Genauigkeit aufweist, indem Messwerte von beiden Leitungsenden verwendet werden. Hierbei müssen die fehlerortungsbezogenen Messwerte über eine geeignete Kommunikationsverbindung zusammengeführt werden. Mithilfe von Schätzverfahren und nichtlinearen Optimierungsverfahren wird eine große Genauigkeit (Messfehler ca. 1-2%) bei der Fehlerortung erreicht.

Das eingangs genannte Verfahren ist aus der US 8,655,609 B2 bekannt. Dort ist ein zweiseitiges Wanderwellen-Fehlerortungsverfahren offenbart. Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- bzw.

Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers durchführen. Nachteilig bei diesem Verfahren ist, dass bei der Berechnung des Fehlerortes die genaue Propagationsgeschwindigkeit der Wanderwellen angegeben werden muss. Diese kann jedoch von Netz zu Netz schwanken und ist nicht immer genau ermittlbar.

Die für die zweiseitige Wanderwellen-Fehlerortung benötigte Infrastruktur erfordert einerseits eine Kommunikationsverbindung zwischen den Messgeräten an den unterschiedlichen Messstellen und andererseits eine genaue Zeitsynchronisation der beiden Messgeräte. Alternativ kann zusätzlich zu den beiden Messgeräten im Feld eine zentrale Auswerteeinheit eingesetzt werden, die über Kommunikationsverbindungen zu beiden Messgeräten verfügt. Der damit verbundene gerätetechnische Aufwand schränkt aktuell die Attraktivität der Wanderwellen-Fehlerortung aus wirtschaftlichen Gründen auf vergleichsweise teure Hoch- und Höchstspannungsanwendungen ein. Somit werden derartige Fehlerortungssysteme bevorzugt dort eingesetzt, wo die schnellere Wiederverfügbarkeit der fehlerbehafteten Leitung eine aufwändige Infrastruktur rechtfertigt.

Aus der WO 2016/118584 A1 ist ein Verfahren zur einseitigen Wanderwellen-Fehlerortung bekannt, das auf dem Vergleich von während eines geplant herbeigeführten Fehlerereignisses erzeugten Wanderwellen mit den während eines Fehlers erzeugten Wanderwellen basiert. Hierzu werden jedoch aufwendige Vergleichsmessungen für die messtechnische Aufzeichnung der Wanderwellen bei einem geplanten Fehlerereignis erforderlich.

Aufgabe der Erfindungs ist es, ein Verfahren der eingangs genannten Art, also eine Fehlerortung nach dem zweiseiten Wanderwellenprinzip, zu schaffen, das genau und gleichzeitig kostengünstig ist.

Die Erfindung löst diese Aufgabe dadurch, dass nach dem Feststellen des Vorliegens einer Wanderwelle an beiden Messstellen mit Hilfe der ersten Reflexion der besagten Wanderwelle an der jeweiligen Sammelschiene und an dem Fehlerort ein Laufzeitverhältnisfaktor $F$ berechnet wird, der die Laufzeit der Wanderwelle von dem Fehlerort zur ersten Messtelle im Verhältnis zur Laufzeit der besagten Wanderwelle von der ersten zur zweiten Messtelle angibt, und dadruch dass die Entfernung $X$ des Fehlerortes von der ersten Messstelle aus dem Produkt aus dem Laufzeitverhältnisfaktor $F$ und der Gesamtlänge $L_{ab}$, gemäß

$$X = F \cdot L_{ab},$$

berechnet wird.

Im Rahmen der Erfindung wird eine zweiseitige Wanderwellen-Fehlerortung bereitgestellt, die ohne hochgenaue Zeitsynchronisation zwischen den Messstellen auskommt. Dadurch reduziert sich der gerätetechnische Aufwand beträchtlich. Darüberhaus geht die Propagations- oder Ausbreitungsgeschwindigkeit der Wanderwelle im Rahmen der Erfindung nicht mehr in die Ermittlung des Fehlerortes ein. Hieraus resultierende Ungenauigkeiten sind im Rahmen der Erfindung folglich vermieden. Auch spielen Fehlerfaktoren, die durch die unterschiedleichen Längen der Signalleitungen zwischen Messsensoren und dessen Anschlussgerät entstehen, im Rahmen der Erfindung ebenfalls keine Rolle.

Das erfindungsgemäße Verfahren ist an vorbekannte Verfahren der einseitigen Wanderwellenfehlerortung angelehnt. Im Rahmen der Erfindung wird an beiden Messtellen unabhängig voneinander das Auftreten einer Wanderwelle und deren Reflexion am Fehlerort erfasst. Dabei werden die hochfrequenten Flanken der Wanderwelle bzw. der Reflexion der Wanderwelle messtechnisch erfasst und mit einem Zeitstempel versehen. Reflexionen der im Fehlerfall auftretenden Wanderwelle finden zum Einen am Ort der Messtelle oder genauer gesagt, an der dort ebenfalls angeordneten Sammelschiene statt. Die von der Sammelschiene refletierte Wanderwelle läuf den Weg bis zum Fehlerort zurück und wird dort ebenfalls reflektiert und wandert zurück zur Messtelle, wo die Flanke dieser ersten Reflexion messtechnisch erfasst und mit einem zweiten Zeitstempel versehen wird. Das Eintreffen der durch den Fehler im Energieversorgungsnetz ausgelöste Wanderwelle und deren eben beschriebene erste Reflexion kann an beiden Messstellen nachgewiesen werden. Im Rahmen der Erfindung werden die Zeitdauern zwischen dem Erfassen der Wanderwelle und derern erster Reflexion an beiden Messstellen berücksichtigt.

"In unmittelbarer Nähe einer Sammelschiene angeordnet" soll im Rahmen der Erfindung bedeuten, dass die Messstelle leitungsseitig der Sammelschiene und zwar in einer Entfernung von 0,01 bis 100 Metern bis zur Sammelschiene angeordnet ist. Der Begriff "Sammelschiene" soll hier stellvertretend für alle Bauteile stehen, an denen eine Reflexion einer Wanderwelle erfolgen kann. Im Rahmen der Erfindung kann die Messstelle auch an der Sammelschiene selbst angeordnet sein. Mit anderen Worten erfolgt die Messung an der Sammelschiene. Bei den besagten geringen Entfernungen (0,01 bis 100 Metern ) zwischen Messstelle und Sammelschiene kann man in guter Näherung bei der Ermittlung des Fehlerortes annehmen, dass die Reflxion quasi an den Messtellen erfolgt. Bei größeren Entfernungen zwischen den Messtellen und der jeweiligen Sammelschiene müsste die Entfernng zwischen Messstelle und der jeweiligen Sammelschiene jedoch bei der Fehlerortung mit berücksichtigt werden.

Vorteilhafterweise ist der Leiterabschnitt zwischen der ersten und der zweiten Messtelle als maschen- und knotenfreier Leiter ausgebildet ist. Mit anderen Worten wird gemäß dieser Weiterentwickliung der Erfindung ein linearer Leiter überwacht. Dies vereinfacht die messtechnische Erfassung der Wanderwellen. Insbesondere ist das Erkennen der ersten Reflexion der Wanderwelle an dem Fehlerort gegenüber anderen störenden Reflexionen vereinfacht.

Bevorzugt wird der Laufzeitverhältnisfaktor $F$ ausschließlich aus einer Zeitdifferenz $\Delta t_a$, die an der ersten Messtelle erfasst wird, und einer Zeitdifferenz $\Delta t_b$, die an der zweiten Messtelle erfasst wird, gebildet. Dabei ist ein Vergleich der Zeitstempel der einen Messstelle mit einem Zeitstempel der zweiten Messtelle vermieden.

Gemäß einer diesbezüglichen Weiterentwicklung der Erfindung werden an der ersten Messstelle die Zeitpunkte $t_{a1}$ und $t_{a2}$ erfasst und $\Delta t_a$ wird gemäß $\Delta t_a = \frac{1}{2}(t_{a2} - t_{a1})$ berechnet, wobei $t_{a1}$ den Zeitpunkt des Eintreffens der Wanderwelle und $t_{a2}$ den Zeitpunkt des Eintreffens der ersten Reflexion der besagten Wanderwelle an der ersten Messstelle angeben. Gleichzeitig werden an der zweiten Messstelle die Zeitpunkte $t_{b1}$ und $t_{b2}$ erfasst, wobei $\Delta t_b$ gemäß $\Delta t_b = \frac{1}{2}(t_{b2} - t_{b1})$ erechnet wird, wobei $t_{b1}$ den Zeitpunkt des Eintreffens der Wanderwelle und $t_{b2}$ den Zeitpunkt des Eintreffens der Reflexion der Wanderwelle an der zweiten Messstelle angeben. Auch hier wird die eintreffende Wanderwelle zunächst an der Sammelschiene also quasi an der Messstelle und anschließend an dem Fehlerort reflektiert. Grundsätzlich gilt, dass eine Wanderwelle beliebig oft zwischen dem Fehlerort und der Sammelschiene reflektiert wird. Dabei nimmt die Amplitude der Welle stetig ab, die Laufzeit von der Fehlerstelle zur Sammelschiene bleibt jedoch gleich. Die erste Reflexion kann jedoch mit ausreichender Genauigkeit nachgewiesen werden. Wenn mehrere Reflexionen von der Fehlerstelle messbar sind, können diese im Sinne der Erfindung zur Verifikation der aus der ersten Reflexion ermittelten Zeitdifferenzen $\Delta t_a$ und $\Delta t_b$ genutzt werden. Dies muss zunächst sichergestellt werden. Ferner ist es zur Absicherung der Messungen zweckmäßig, wenn die Laufzeit über die gesamte Leitung, die aus der Summe von $\Delta t_a$ und $\Delta t_b$ berechnet wird, mit einem zuvor festgelegten "Sollwert" für die Laufzeit über die Leitung verglichen wird. Darüber hinaus kann die erfindungsgemäße Fehlerortung mit Hilfe einer zweiseitigen Fehlerortung mit hochgenauer Zeitsynchronisation überprüft werden.

Gemäß einer bevorzugten Variante des erfindungsgemäßen Verfahrens wird der Laufzeitverhältnisfaktor $F$ gemäß $F = \frac{\Delta t_a}{\Delta t_a + \Delta t_b}$ berechnet.

Gemäß einer Weitereentwicklung der Erfindung wird die Laufzeit der Wanderwelle vom Fehlerort zur ersten Messtelle aus der Differenz der Zeitpunkte des Eintreffens $t_{a2}$ der Reflexion der Wanderwelle an der ersten Messstelle und des Eintreffens $t_{a1}$ der Wanderwelle an der ersten Messstelle gemäß $\Delta t_a = \frac{1}{2}(t_{a2} - t_{a1})$ ermittelt.

Gemäß dieser diesbezüglichen Weiterentwicklung wird die Laufzeit der besagten Wanderwelle von der ersten zur zweiten Messstelle $t_{ab}$ aus der Summe der Laufzeit der Wanderwelle vom Fehlerort zur ersten Messstelle $\Delta t_a$ und der Laufzeit der Wanderwelle vom Fehlerort zur zweiten Messstelle $\Delta t_b$ gemäß $t_{ab} = \Delta t_a + \Delta t_b$,

berechnet, wobei $\Delta t_b = \frac{1}{2}(t_{b2} - t_{b1})$ entspricht und wobei $t_{b2}$ den Zeitpunkt des Eintreffens der Reflexion der Wanderwelle an der zweiten Messstelle und $t_{b1}$ den Zeitpunkt des Eintreffens der Wanderwelle an der zweiten Messstelle angeben.

Vorteilhafterweise sind im Rahmen der Erfindung zwei IEDs vorgesehen, die über eine Kommunikationsverbindung mit einer Leitstellenanordnung verbunden sind, wobei die Leitstellenanordnung die Lokalisierung des Fehlerortes vornimmt.

Abweichend davon sind die IEDs über eine Kommunikationsverbindung miteinander verbunden, so dass eine Übermittlung der Messwerte zwischen den IEDs ermöglicht ist. Der Fehlerort kann dann von einem der IEDs berechnet werden.

Leitstellenanordnungen sind einzelne oder Gruppen von zentral oder dezentral angeordneten Datenverarbeitungseinrichtungen, die meist komplexe Algorithmen zur Beobachtung und/oder zur Steuerung der Anlage ausführen. Leitstellenanordnungen besitzen üblicherweise eine Mensch-Maschine-Schnittstelle, die es einem Betreiber der Anlage ermöglicht, den Zustand der Anlage insgesamt sowie denjenigen der einzelnen Komponenten der Anlage zu beobachten und zu überwachen und steuernd auf einzelne oder mehrere Komponenten einzuwirken.

Die Leistellenanordnung kann im Rahmen der Erfindung auch durch eine Datenverarbeitungs-Cloud realisiert sein. Unter einer Datenverarbeitungs-Cloud soll hierbei eine Anordnung mit einer oder mehreren Datenspeichereinrichtungen und einer oder mehreren Datenverarbeitungseinrichtungen verstanden werden, die durch geeignete Programmierung zur Durchführung beliebiger Datenverarbeitungsprozesse ausgebildet werden kann. Die Datenverarbeitungseinrichtungen stellen hierbei in der Regel universelle Datenverarbeitungseinrichtungen (z.B. Server) dar, die hinsichtlich ihrer Konstruktion und ihrer Programmierung zunächst keinerlei spezifische Auslegung aufweisen. Erst durch eine vorgenommene Programmierung lässt sich die universelle Datenverarbeitungseinrichtung zur Ausführung spezifischer Funktionen ertüchtigen. Sofern die Datenverarbeitungs-Cloud mehrere einzelne Komponenten aufweist, sind diese auf geeignete Weise zur Datenkommunikation miteinander verbunden (z.B. durch ein Kommunikationsnetzwerk). Einer Datenverarbeitungs-Cloud können beliebige Daten zur Datenspeicherung und/oder -verarbeitung zugeführt werden. Die DatenverarbeitungsCloud selbst stellt die gespeicherten Daten und/oder die Ergebnisse der durchgeführten Datenverarbeitung wiederum anderen Geräten, z.B. einer mit der Datenverarbeitungs-Cloud verbundenen Computer-Arbeitsstation (Workstation), zur Verfügung. Der hier verwendete Begriff Leitstellenanordnung soll sich im Rahmen der Erfindung auch auf eine solche Datenverarbeitungs-Cloud erstrecken. Eine Datenverarbeitungs-Cloud kann beispielsweise auch durch ein Rechenzentrum oder auch mehrere vernetzte Rechenzentren bereitgestellt werden. Üblicherweise ist eine Datenverarbeitungs-Cloud räumlich entfernt von der Anlage aufgestellt.

Intelligente elektronische Geräte (so genannte IEDs - intelligent electronic devices) sind in der Lage, unter Ausführung bestimmter Algorithmen selbständig Aufgaben zur Automatisierung oder zum Schtz eines elektrischen Energieversogungsnetze wahrzunehmen. IEDs können in diesem Zusammenhang insbesondere Schutz- und Steuergeräte, Messgeräte, Power Quality Geräte oder Leistungsmessgeräte (Power Meter) sein.

Unter einer Kommunikationverbindung sind im Rahme der Erfindung sowohl drahtgebundene Verbindungsleitungen also auch drahtfreie (wireless) Funkverbindungen zu verstehen.

Weitere zweckmäßige Ausgestaltungen und Vorteile der Erfindung sind Gegenstand der nachfolgenden Beschreibung von Ausführungsbeispielen der Erfindung unter Bezug auf die Figur der Zeichnung, wobei die

Figur ein Ausführungsbeispiel des erfindungsgemäßen Verfahrens schematisch verdeutlicht. Die Figur verdeutlicht ein Ausführungsbeispiel des erfindungsgemäßen Verfahrens. Das elektrische Energieversorgungsnetz ist in dem gezeigten Beispiel durch eine lineare maschen- und knotenfreie Leitung 1 ausgestaltet, die dreiphasig ausgeführt ist. Die Leitung 1 umfasst mit anderen Worten drei einzelne Phasenleiter. Dies ist figürlich nicht dargestellt. Der Leiter 1 erstreckt sich von einer ersten Sammelschiene 2 zu einer zweiten Sammelschiene 3. Ferner sind zwei Messstellen a und b erkennbar, wobei die Messstelle a in unmittelbarer Nähe der Sammelschiene 2 und die Messstelle b in unmittelbarer Nähe der Sammelschiene 3 angeordnet sind. In dem gezeigten Ausführungsbeispiel beträgt der Abstand zwischen der jeweiligen Messstelle und der Sammelschiene fünf Meter. An der Messstelle a befindet sich der Messsensor 4a, an der Messstelle b befindet sich der Messsensor 4b. Beide Messsensoren sind als Spannungswandler ausgebildet. Im Rahmen der Erfindung können jedoch auch Stromwandler oder Kleinsignalwandler beispielsweise eine Rogowski-Spule zum Einsatz gelangen.

Jeder Messsensor 4a, 4b ist mit dem Messgeräteeingang eines intelligenten elektronischen Geräts (IED) 5a bzw. 5b verbunden. In dem gezeigten Ausführungsbeispiel sind die IEDs 5a, 5b Schutzgeräte.

Die von den Messensoren ausgangsseitig erzeugten Messignale werden den Schutzgeräten 5a bzw. 5b zugeführt. Jedes Schutzgerät 5a und 5b tastet die analogen Messignale unter Gewinnung von Abtastwerten ab, wobei die Abtastwerte anschließend durch einen Analogdigitalwandler unter Gewinnung von Messwerten digitalisiert werden.

In der Figur ist ferner angedeutet, dass in der Leitung 1 an einem Fehlerort 7 ein Kurzschluss vorliegt. Der Kurzschluss selbst ist durch einen gezackten Pfeil 6 verdeutlicht. An dem Fehlerort 7 entstehen auf Grund des Kurzschlusses Wanderwellen 8a und 8b, wobei die Wanderwelle 8a vom Fehlerort 7 auf die Messstelle a zu wandert und die Wanderwelle 8b sich von dem Fehlerort 7 zur Messstelle b zu bewegt. Bei den besagten Wanderwellen 8a bzw. 8b handelt es sich um sogenannte transiente Signalanteile, die hochfrequent sind.

Unterhalb Leitung 1 und den Schutzgeräten 5a, 5b sind in der Figur zwei Zeitstrahle ta und tb erkennbar, welche die Zeitaufzeichnung des jeweiligen Schutzgeräts 5a bzw. 5b verdeutlichen sollen. Die Schutzgeräte 5a und 5b verfügen für die Zeitmessung über eine interne Uhr oder Zeitangabeeinheit, mit deren Hilfe ein Zeitstempel erzeugbar ist. Die Uhren der Schutzgeräte 5a und 5b sind nicht miteinander synchronisiert. In der Figur wird die Zeitaufzeichnung der Uhr des Schutzgeräts 5a mit dem Zeitstahl ta und die Zeitaufzeichnung der Uhr des Schutzgeräts 5b mit dem Zeitstrahl tb verdeutlicht.

Trifft die Wanderwelle 8a an der Messstelle a ein, wird deren hochfrequente Flanke mit dem Zeitstempel $t_{a1}$ versehen. Der Zeitpunkt $t_{a1}$ gibt mit anderen Worten das Eintreffen der Wanderwelle 8a an der Messstelle a an. Dies ist mit Pfeil schematisch dargestellt, dessen Spitze den Zeitstrahl bei $t_{a1}$ berührt. Die Reflexion der Wanderwelle an der Sammelschiene 2 sorgt für einen erneuten Pfeil dessen Spitze auf der gestrichelten Linie liegt, die in der Figur parallel zu den Zeitstrahlen ta und tb verläuft und zwischen diesen angeordnet ist. Am Fehlerort 7, der in der Figur durch die gestrichelte Linie symbolisiert wird, erfolgt eine erneute Reflexion der Wanderwelle 8a die dann wieder an der Messstelle a als erste Reflexion nachgewiesen werden kann. Mit $t_{a2}$ ist auf dem Zeitstrahl ta die Zeit verdeutlicht, an der die erste Reflexion der Wanderwelle an der Messstelle a erfasst wird.

Auf der anderen Seite der Leitung 1, auf der Seite b, wird entsprechend vorgegangen. Das Eintreffen der Wanderwelle 8b an der Messstelle b wird mit dem Zeitstempel $t_{b1}$ versehen. Anschließend wird die Wanderwelle 8b an der Sammelschiene 3 wieder in Richtung des Fehlerortes 7 reflektiert mit einer erneuten Reflexion am Fehlerort 7 im Gefolge. Das Eintreffen der am Fehlerort 7 reflektierten Wanderwelle an der Messstelle b wird mit dem Zeitstempel $t_{b2}$ versehen.

Die Schutzgeräte 5a und 5b sind jeweils über eine Kommunikationsverbindung 9 mit einer Leitstellenanordnung 10 verbunden, mit deren Hilfe die oben aufgeführten Zeitstempel der Wanderwellen 8a und 8b und deren erste Reflexionen zur Leitstellenanordnung 10 übertragen werden. In dem gezeigten Ausführungsbeispiel handelt es sich bei der Kommunikationsverbindung 9 um eine kabellose Funkverbindung. Die Leitstellenanordnung 10 kann nun die Ortung des Kurzschlusses vornehmen also die Entfernung des Fehlerortes von der Messstelle a bestimmen oder eingrenzen.

Um den Fehlerort 7, also die Entfernung X des Fehlerortes 7 von der Messstelle a zu ermitteln, wird im Rahmen der Erfindung mittels der Leitstellenanordnung 10 ein Laufzeitverhältnisfaktor F berechnet. Dieser Faktor F entspricht dem Verhältnis der Laufzeit der Wanderwelle 8a von dem Fehlerort 7 zur Messstelle a im Verhältnis zur Laufzeit einer entsprechenden Wanderwelle über die gesamte Länge der Leitung 1 von der Messstelle a zur Messstelle b. Diese Entfernung wird im Folgenden mit Lab bezeichnet.

Die Laufzeit der Wanderwelle 8a vom Fehlerort 7 zur ersten Messstelle a wird erfindungsgemäß aus der Differenz der Zeitpunkte des Eintreffens der ersten Reflexion der Wanderwelle $t_{a2}$ und des Eintreffens der Wanderwelle $t_{a1}$ jeweils an der ersten Messstelle gemäß

$$\Delta t_a = \frac{1}{2}(t_{a2} - t_{a1})$$ ermittelt. Die Laufzeit einer entsprechenden Wanderwelle von der ersten a zur zweiten Messstelle b, die mit $t_{ab}$ angegeben wird, kann aus der Summe der Laufzeit der Wanderwelle 8a vom Fehlerort 7 zur ersten Messstelle a, die mit $\Delta t_a$ angegeben ist, und der Laufzeit der Wanderwelle 8b vom Fehlerort 7 zur zweiten Messstelle b ($\Delta t_b$) gemäß $t_{ab} = (\Delta t_a + \Delta t_b)$, berechnet

werden, wobei $\Delta t_b = \frac{1}{2}(t_{b2} - t_{b1})$ berechnet wird. Somit kann der Laufzeitverhältnisfaktor F gemäß

$F = \frac{\Delta t_a}{\Delta t_a + \Delta t_b}$ berechnet werden und der Abstand X

von der Messstelle a ergibt sich nach $X = F \cdot L_{ab} = \frac{\Delta t_a}{\Delta t_a + \Delta t_b} L_{ab}$ .

**Patentansprüche**

1. Verfahren zum Ermitteln eines Fehlerortes (7) in einem elektrischen Energieversorgungsnetz (1), bei dem

> a. an einer ersten (a) und einer zweiten (b) Messstelle in dem Energieversorgungsnetz (1) mittels jeweils eines Messsensors (4a, 4b) jeweils eine elektrische Messgröße unter Gewinnung von einem ersten beziehungsweise einem zweiten Messsignal erfasst werden, wobei jede Messstelle in unmittelbarer Nähe oder an einer Sammelschiene angeordnet ist und jeder Messsensor (4a, 4b) mit jeweils einem intelligenten elektronischen Gerät IED (5a, 5b) verbunden ist und $L_{ab}$ die Gesamtlänge des Leiterabschnitts des Energieversorgungsnetzes zwischen der ersten (a) und der zweiten Messstelle (b) oder den Sammelschienen angibt,
> b. die Messsignale der ersten Messstelle (a) und der zweiten Messstelle (b) jeweils auf das Vorhandensein einer Wanderwelle (8a, 8b) untersucht werden; **dadurch gekennzeichnet, dass**
> c. nach dem Feststellen des Vorliegens einer Wanderwelle (8a, 8b) an beiden Messstellen mit Hilfe der zeitlich ersten Reflexion der besagten Wanderwelle an der jeweiligen Sammelschiene (a bzw. b) und daran anschließend an dem Fehlerort (7) ein Laufzeitverhältnisfaktor *F* berechnet wird, der die Laufzeit der Wanderwelle (8a) vom Fehlerort (7) zur ersten Messstelle (a) im Verhältnis zur Laufzeit der besagten Wanderwelle (8a, 8b) von der ersten (a) zur zweiten Messstelle (b) angibt, und
d. die Entfernung *X* des Fehlerortes (7) von der ersten Messstelle (a) aus dem Produkt aus dem Laufzeitverhältnisfaktor *F* und der Gesamtlänge $L_{ab}$, gemäß

$$X = F \cdot L_{ab},$$

berechnet wird.

2. Verfahren nach nach Anspruch 1, **dadurch gekennzeichnet, dass** der Laufzeitverhältnisfaktor *F* ausschließlich aus einer Zeitdifferenz $\Delta t_a$, die an der ersten Messstelle (a) erfasst wird, und einer Zeitdifferenz $\Delta t_b$, die an der zweiten Messstelle (b) erfasst wird, gebildet wird.

3. Verfahren nach Anspruch 2, **dadurch gekennzeichnet, dass** an der ersten Messstelle (a) die Zeitpunkte $t_{a1}$ und $t_{a2}$ erfassst werden und $\Delta t_a$ gemäß $\Delta t_a = \frac{1}{2}(t_{a2} - t_{a1})$ berechnet wird, wobei $t_{a1}$ den Zeitpunkt des Eintreffens der Wanderwelle (8a) und $t_{a2}$ den Zeitpunkt des Eintreffens der ersten Reflexion der besagten Wanderwelle (8a) und dass an der zweiten Messstelle (b) die Zeitpunkte $t_{b1}$ und $t_{b2}$ erfasst werden und $\Delta t_b$ gemäß

$\Delta t_b = \frac{1}{2}(t_{b2} - t_{b1})$ berechnet wird, wobei $t_{b1}$ den Zeitpunkt des Eintreffens der Wanderwelle (8b) und $t_{b2}$ den Zeitpunkt des Eintreffens der ersten Reflexion der Wanderwelle (8b) an der zweiten Messstelle (b) angeben.

4. Verfahren nach Anspruch 3, **dadurch gekennzeichnet, dass** der Laufzeitverhältnisfaktor *F* gemäß $F = \frac{\Delta t_a}{\Delta t_a + \Delta t_b}$ berechnet wird.

5. Verfahren nach einem der vorhergehenden Ansprüche, **dadurch gekennzeichnet, dass** die Laufzeit der Wanderwelle (8a) vom Fehlerort (7) zur ersten Messstelle (a) aus der Differenz der Zeitpunkte des Eintreffens $t_{a2}$ der ersten Reflexion der Wanderwelle und des Eintreffens $t_{a1}$ der Wanderwelle an der ersten Messstelle gemäß $\Delta t_a = \frac{1}{2}(t_{a2} - t_{a1})$ ermittelt wird.

6. Verfahren nach Anspruch 5, **dadurch gekenn-**

**zeichnet, dass** die Laufzeit der besagten Wanderwelle (8b) von der ersten (a) zur zweiten Messstelle (b) $t_{ab}$ aus der Summe der Laufzeit der Wanderwelle (8a) vom Fehlerort (7) zur ersten Messstelle (a) $\Delta t_a$ und der Laufzeit der Wanderwelle (8b) vom Fehlerort (7) zur zweiten Messstelle (b) $\Delta t_b$ gemäß $t_{ab}$ = ($\Delta t_a$ + $\Delta t_b$) berechnet wird, wobei $\Delta t_b = \frac{1}{2}(t_{b2} - t_{b1})$ entspricht und wobei $t_{b2}$ den Zeitpunkt des Eintreffens der ersten Reflexion der Wanderwelle an der zweiten Messstelle und $t_{b1}$ den Zeitpunkt des Eintreffens der Wanderwelle an der zweiten Messstelle angeben.

7. Verfahren nach einem der vorhergehenden Ansprüche, **dadurch gekennzeichnet, dass** beide IEDs (5a, 5b) jeweils über eine Kommunikationsverbindung (9) mit einer Leitstellenanordnung (10) verbunden sind, wobei die Leitstellenanordnung (10) die Lokalsierung des Fehlerortes vornimmt.

8. Verfahren nach einem der vorhergehenden Ansprüche, **dadurch gekennzeichnet, dass** beide IEDs (5a, 5b) jeweils eine Uhr aufweisen, wobei die Uhren nicht miteinander synchronisiert sind.

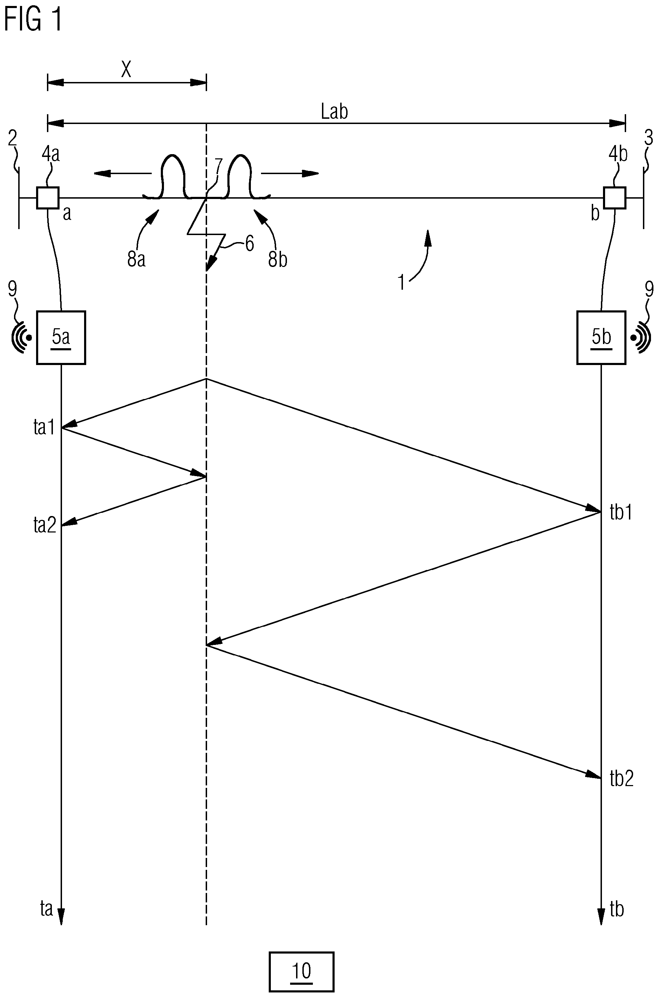

FIG 1

Europäisches
Patentamt

European
Patent Office

Office européen
des brevets

## EUROPÄISCHER RECHERCHENBERICHT

**Nummer der Anmeldung**

EP 24 20 1061

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 11 204 382 B2 (ABB POWER GRIDS SWITZERLAND AG [CH] ET AL.) 21. Dezember 2021 (2021-12-21) * Anspruch 1; Abbildungen 4,5,8,9 * ----- | 1-8 | INV. G01R31/08 G01R31/11 H02H7/26 |
| A | US 2020/400734 A1 (NAIDU OBBALAREDDI DEMUDU [IN]) 24. Dezember 2020 (2020-12-24) * Anspruch 1; Abbildungen 1a,1b,2,3 * ----- | 1-8 | |
| A | AFTAB MOHD ASIM ET AL: "Dynamic protection of power systems with high penetration of renewables: A review of the traveling wave based fault location techniques", INTERNATIONAL JOURNAL OF ELECTRICAL POWER & ENERGY SYSTEMS, JORDAN HILL, OXFORD, GB, Bd. 114, 11. Juli 2019 (2019-07-11), XP085797834, ISSN: 0142-0615, DOI: 10.1016/J.IJEPES.2019.105410 [gefunden am 2019-07-11] * das ganze Dokument * ----- | 1-8 | |

**RECHERCHIERTE SACHGEBIETE (IPC)**

G01R
H02H

Der vorliegende Recherchenbericht wurde für alle Patentansprüche erstellt

| Recherchenort | Abschlußdatum der Recherche | Prüfer |
|---|---|---|
| München | 26. Februar 2025 | O'Callaghan, D |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 24 20 1061

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-02-2025

| Im Recherchenbericht angeführtes Patentdokument | Datum der Veröffentlichung | Mitglied(er) der Patentfamilie | Datum der Veröffentlichung |
|---|---|---|---|
| US 11204382 B2 | 21-12-2021 | CN 111386468 A | 07-07-2020 |
| | | EP 3710842 A1 | 23-09-2020 |
| | | US 2021003625 A1 | 07-01-2021 |
| | | WO 2019097311 A1 | 23-05-2019 |
| US 2020400734 A1 | 24-12-2020 | CN 111433616 A | 17-07-2020 |
| | | EP 3710843 A1 | 23-09-2020 |
| | | US 2020400734 A1 | 24-12-2020 |
| | | WO 2019097312 A1 | 23-05-2019 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2476002 B1
- US 4996624 A
- US 5929642 A
- US 8655609 B2
- WO 2016118584 A1